# EUROPÄISCHE PATENTANMELDUNG

(11) **EP 2 746 694 A1**
(43) Veröffentlichungstag der Anmeldung: **25.06.2014**
(21) Anmeldenummer: 13185163.6
(22) Anmeldetag: 19.09.2013
(51) Int. Cl.: F24J 2/24, F24D 3/14, F24J 2/00, F24D 3/16

(54) **Thermoanordnung, Verfahren zum Herstellen einer Thermoanordnung und Verfahren zum Montieren einer Thermoanordnung**

(30) Priorität: 19.09.2012 DE 102012216823
(71) Anmelder: HQNB Produktions- und Verwertungsgesellschaft UG (haftungsbeschränkt), 10115 Berlin (DE)
(72) Erfinder: Böttcher, Bernhard, 16761 Hennigsdorf (DE)
(74) Vertreter: Staroske, Sandro

(57) **Zusammenfassung**

Die Erfindung betrifft eine Thermoanordnung, mit
- einer Leitung zum Führen eines Mediums, das Wärme aus der Umgebung aufnehmen und/oder Wärme an die Umgebung abgeben kann; und
- einem Materialbereich (1a, 1 b), in den die Leitung zumindest teilweise eingebettet ist, wobei
- die Leitung in Form eines Wellrohres (3) ausgebildet ist.

Die Erfindung betrifft auch ein Verfahren zum Herstellen einer derartigen Thermoanordnung sowie ein Verfahren zum Montieren einer Thermoanordnung.

## Beschreibung

Die Erfindung betrifft eine Thermoanordnung gemäß Anspruch 1, ein Verfahren zum Herstellen einer derartigen Thermoanordnung gemäß Anspruch 13 sowie ein Verfahren zum Montieren einer Thermoanordnung nach Anspruch 15.

Aus dem Stand der Technik sind zum Beispiel Thermoanordnungen in Form von Solarthermieanlagen bekannt, die in eine in einen Materialbereich eingebettete Leitung aufweisen, durch die ein Medium (Wärmemedium) strömt, das durch Sonneneinstrahlung erwärmbar ist. Darüber hinaus sind Thermoanordnungen mit einer in einen Materialbereich eingebetteten Leitung auch als Heiz- oder Klimatisierungselemente bekannt, die zur Temperierung eines Raumes zum Beispiel in einen Fußboden, eine Decke oder eine Wand des Raumes integriert sind.

Das von der Erfindung zu lösende Problem besteht darin, eine möglichst effiziente und dennoch auf möglichst einfache Weise herstellbare Thermoanordnung zu schaffen. Des Weiteren soll ein Herstellungsverfahren für eine derartige Thermoanordnung sowie eine Möglichkeit zum effizienten Betreiben einer Thermoanordnung angegeben werden.

Diese Probleme werden durch die Bereitstellung der Thermoanordnung gemäß Anspruch 1 sowie durch die Verfahren nach den Ansprüche 13 und 15 gelöst. Weiterbildungen der Erfindung sind in abhängigen Ansprüchen angegeben.

Danach wird eine Thermoanordnung bereitgestellt, mit
- einer Leitung zum Führen eines (flüssigen oder gasförmigen) Mediums, das Wärme aus der Umgebung aufnehmen (d.h. z.B. als Kühlung betrieben werden kann) und/oder Wärme an die Umgebung abgeben kann (d.h. z.B. als Heizung betrieben werden kann); und
- einem Materialbereich, in den die Leitung zumindest teilweise eingebettet ist, wobei
- die Leitung in Form eines Wellrohres ausgebildet ist.

Die Verwendung eines Wellrohres als Leitung zum Führen des Mediums erleichtert nicht nur das Anordnen und Formen der Leitung, sondern kann überraschenderweise auch ein effizienteres Durchströmen der Leitung und damit eine Reduktion der zum Hindurchpumpen durch die Leitung erforderlichen Pumpleistung (insbesondere einer Umwälzpumpe) bewirken, d.h. einen synergistischen Effekt hervorbringen. Die mögliche Reduktion der erforderlichen Pumpleistung ist insbesondere darauf zurückzuführen, dass durch die wellenförmige Gestalt der Wandung des Wellrohrs, die das innere, befüllbare Volumen des Wellrohrs begrenzt, jeweils im Bereich der Wellenbäuche der Wellrohrwandung Wirbel im Medium erzeugt werden können, wodurch eine turbulente Strömung mit geringerem Strömungswiderstand entsteht. Die im Medium hervorgerufenen lokalen Wirbel erzeugen insbesondere einen Sog (Mikrosog) in Richtung der Strömungsrichtung des Mediums, der wie ein reduzierter Strömungswiderstand wirkt und daher zur Folge hat, dass sich die zur Beförderung des Mediums durch die Thermoanordnung erforderliche Pumpleistung vermindert.

Bei dem Wellrohr handelt es sich beispielsweise um ein Metallrohr (etwa um ein Edelstahlrohr), wobei das Wellrohr insbesondere in Form eines Schlauches und z.B. mit zumindest näherungsweise kreisförmigem oder elliptischen Querschnitt ausgebildet ist. Denkbar ist natürlich auch, dass das Wellrohr nicht aus einem Metall besteht, sondern z.B. aus einem Kunststoff.

Dass die Leitung "zumindest teilweise" in den Materialbereich eingebettet ist, bedeutet zum Beispiel, dass die Leitung nicht über ihre gesamte Länge von dem Materialbereich und/oder dass nicht der gesamte Umfang der Leitung von dem Materialbereich umgeben ist. Möglich ist natürlich durchaus auch, dass sich der Materialbereich um den gesamten Umfang der Leitung herum erstreckt. Die Leitung weist insbesondere zumindest eine Krümmung auf, über die zum Beispiel zwei zumindest näherungsweise parallel zueinander ausgerichtete Teilabschnitte der Leitung miteinander verbunden sind. Es ist allerdings auch denkbar, dass die Leitung ausschließlich geradlinig in dem Materialbereich verläuft. Insbesondere könnte zumindest ein geradliniger Teilabschnitt der Leitung einen Winkel mit der Horizontalen einschließen, z.B. im Bereich von 10 bis 30°, d.h. unter einem gewissen Winkel nach oben weisen.

Der Materialbereich weist insbesondere ein möglichst gut wärmeleitendes Material auf, um Wärmeenergie mit möglichst geringen Verlusten aus der Umgebung auf das Wellrohr und damit auf das Medium bzw. umgekehrt von dem Medium auf die Umgebung übertragen zu können. Der wellenförmige Querschnitt der Wandung des Wellrohrs erhöht im Vergleich zu einer "glatten" Leitung die Kontaktfläche der Leitung mit dem sie umgebenden Materialbereich, was den Wärmeübertrag in das Medium bzw. von dem Medium in die Umgebung erhöhen kann (zum Beispiel um mehr als das 1,5-fache gegenüber einer glatten Leitung, d.h. einer Leitung mit einer planen Wandung).

Darüber hinaus kann durch die wellenförmige Ausgestaltung der Wandung der Leitung gewissermaßen eine "Verzahnung" der Leitung mit dem Materialbereich entstehen, sodass ein besonders guter thermischer Kontakt zwischen der Leitung und dem Materialbereich entsteht, der z.B. auch über einen großen Temperaturbereich des durch die Leitung strömenden Mediums besteht. Insbesondere wird durch die Ausgestaltung der Leitung als Wellrohr der Gefahr entgegengewirkt, dass an der Leitungsaußenseite durch ein Ausdehnen oder Zusammenziehen der Leitung bei Erwärmung bzw. Abkühlung luftgefüllte Hohlräume entstehen, die den Wärmekontakt zwischen der Leitung und der Umgebung verschlechtern.

Gemäß einer Ausgestaltung der Erfindung weist der Materialbereich einen Materialschaum auf oder ist aus einem Materialschaum gebildet. Denkbar ist, dass als Materialschaum ein Graphitschaum verwendet wird. Der Materialschaum wird insbesondere nach dem Anordnen an dem Wellrohr verpresst, so dass die Thermoanordnung eine zumindest im Wesentlichen plattenförmige Form erhält. Beispielsweise wird der Materialschaum in Form zweier Materialschaumplatten bereitgestellt, zwischen denen das Wellrohr angeordnet ist, wobei die Anordnung aus den Materialschaumplatten und dem Wellrohr verpresst wird. Die oben erwähnte Verzahnung der Leitungswandung mit dem Materialbereich kann eine im Vergleich mit einer glatten Leitung erhöhte Steifigkeit der Thermoanordnung nach dem Verpressen hervorrufen. Beispielsweise lässt sich somit bei Verwendung der Thermoanordnung als Bestandteil eines Hybrid-Photovoltaikmoduls (s.u.) die Steifigkeit des Photovoltaikmoduls erhöhen.

Graphitschaum ist gut wärmeleitend, gut wärmespeichernd und weist dennoch eine relativ geringe Dichte auf. Zudem ist Graphitschaum schwer entflammbar, so dass auch eine Verwendung der Thermoanordnung als Brandschutz denkbar ist. Beispielsweise kann der Graphitschaum bei einer Verwendung der erfindungsgemäßen Thermoanordnung in einem Photovoltaikmodul die Wärme (z.B. von der Rückseite, d.h. von der auf der der Sonneneinstrahlung abgewandten Seite des Photovoltaikmoduls) in sehr kurzer Zeit - z.B. innerhalb von höchstens 5 Sekunden - aufnehmen. Auch die Wärmeverteilung innerhalb des Graphitschaums erfolgt insbesondere sehr schnell und gleichförmig. Aufgrund der relativ geringen Dichte des Graphitschaums wird das Gewicht des Photovoltaikmoduls durch das Nachrüsten mit der erfindungsgemäßen Thermoanordnung nur geringfügig, z.B. um ca. 2 kg pro qm, erhöht, so dass das kombinierte Modul (Hybridmodul) z.B. keine nennenswerten zusätzlichen Dachlasten verursacht.

Durch die Verwendung der erfindungsgemäßen Thermoanordnung in einem Photovoltaikmodul kann zudem eine Temperierung (insbesondere Kühlung) des Photovoltaikmoduls erfolgen, um insbesondere einem Abfall der vom Photovoltaikmodul erzeugten elektrischen Leistung entgegenzuwirken. So kann z.B. erreicht werden, dass die Temperatur des Photovoltaikmoduls bei langanhaltender Sonneneinstrahlung weniger steil ansteigt (und insbesondere die Maximaltemperatur des Photovoltaikmoduls reduziert wird) und sich die Abkühlzeit nach Beendigung der Sonneneinstrahlung verlängert. Insbesondere durch die Reduzierung der Maximaltemperatur des Moduls ist es möglich, die mit dem Modul erzeugte Energiemenge zu steigern. Die von der Thermoanordnung aufgenommene Energie kann z.B. zum Erwärmen von Brauchwasser oder eines Mediums eines Heizungssystems verwendet werden.

Beispielsweise kann sich die Temperatur eines konventionellen Photovoltaikmoduls bei längerer Sonneneinstrahlung auf bis zu 100° Celsius erhöhen, wobei sich das Modul nach Sonnenuntergang wieder sehr schnell auf die Umgebungstemperatur abkühlt, z.B. in weniger als 1 Stunde. Durch das Einsetzen einer mit Graphitschaum versehenen erfindungsgemäßen Thermoanordnung in das Photovoltaikmodul kann der Verlauf des Abkühlens durch die Fähigkeit der Wärmespeicherung des Graphitschaums deutlich verlängert werden, z.B. auf mehr als drei Stunden. Dies kann bedeuten, dass die thermomechanische Beanspruchung des Moduls (im Vergleich mit konventionellen Photovoltaikmodulen oder konventionellen hybriden Photovoltaikmodulen) verringert wird, woraus eine erhöhte Lebensdauer des kombinierten Moduls resultiert. Auch ist es möglich, dass aus demselben Grund die Bildung von Mikrorissen in den Modulen reduziert und eine daraus resultierende Reduzierung der Nennleistung der Module verringert wird.

Gemäß einer anderen Weiterbildung der Erfindung umfasst die Thermoanordnung mindestens eine Folie (z.B. eine Metallfolie), die den Materialbereich, in den das Wellrohr eingebettet ist, zumindest teilweise umgibt. Beispielsweise bildet die Folie eine Außenseite der Thermoanordnung.

Möglich ist auch, dass der Materialbereich zumindest eine Öffnung und/oder zumindest eine Vertiefung aufweist, die dazu dient, elektrische und/oder mechanische Komponenten in oder an der Thermoanordnung anbringen zu können. Beispielsweise handelt es sich, wie unten noch weiter erläutert werden wird, bei der Thermoanordnung um einen Bestandteil einer Photovoltaikmodulanordnung, wobei in dem Materialbereich der Thermoanordnung eine Aussparung vorgesehen wird, in die ein Anschluss des Photovoltaikmoduls eingesetzt werden kann.

Denkbar ist auch, wie ebenfalls weiter unten erläutert werden wird, dass die erfindungsgemäße Thermoanordnung als Temperiervorrichtung zum Temperieren eines Raumes verwendet und zum Beispiel in oder an einer Außen- oder Innenseite einer Wand,einer Decke oder eines Bodens eines Gebäudes angeordnet wird. In diesem Fall können in dem Materialbereich der Thermoanordnung Aussparungen vorgesehen sein, in die elektrische oder mechanische Komponenten (z.B. von elektrischen oder sonstigen Versorgungseinrichtungen, etwa Lichtschalter) eingebracht werden können. Die Aussparungen sind insbesondere so ausgebildet, dass die Leitung von dem Materialbereich umhüllt bleibt; ggf. muss der Leitungsverlauf entsprechend angepasst werden.

Die erfindungsgemäße Thermoanordnung kann zudem, insbesondere, wenn sie als Temperiervorrichtung verwendet werden soll, einen Rahmen (insbesondere einen Metallrahmen) aufweisen, in den der Materialbereich mit dem eingebetteten Wellrohr eingesetzt ist, so dass der Rahmen den Materialbereich zumindest teilweise seitlich (d.h. entlang dessen schmaler Seite) umgibt. Denkbar ist auch, dass der Rahmen als Kassette ausgebildet ist, d.h. den Materialbereich nicht nur zumindest teilweise seitlich umgibt, sondern insbesondere auch eine Wand aufweist, die an eine der großen Seitenflächen des Materialbereichs angrenzt.

Wie oben bereits angedeutet, betrifft die Erfindung auch eine (Hybrid-)Photovoltaikmodulanordnung, die neben mindestens einem (konventionellen) Photovoltaikmodul mindestens eine an dem Photovoltaikmodul angeordnete wie oben beschriebene erfindungsgemäße Thermoanordnung aufweist, die als Solarthermiekomponente dient. Die erfindungsgemäße Thermoanordnung ist insbesondere an dem Photovoltaikmodul festgelegt, wobei denkbar ist, dass sie in einem üblicherweise vorhandenen Rahmen des Photovoltaikmoduls angeordnet und insbesondere an diesem Rahmen festgelegt ist. Hierfür ist die erfindungsgemäße Thermoanordnung z.B. so ausgestaltet, dass ein bereits vorhandenes Photovoltaikmodul mit einer Thermoanordnung oder auch mit mehreren Thermoanordnungen nachgerüstet werden kann. Insbesondere können eine etwaig vorhandene Unterkonstruktion und Befestigungsstrukturen, die zur Befestigung des Photovoltaikmoduls an einer Fläche, insbesondere auf einem Dach eines Gebäudes, dienen (z.B. unverändert) weiter verwendet werden.

Die Photovoltaikmodulanordnung weist insbesondere einen Einlass auf, über den das Medium in die Thermoanordnung einströmen kann, sowie einen Auslass, über den das Medium aus der Thermoanordnung ausströmen kann. Einlass und Auslass sind insbesondere so angeordnet, dass das Medium bei Betrieb der Thermoanordnung - bezogen auf den montierten Zustand der Photovoltaikmodulanordnung (zum Beispiel auf dem Dach oder an einer Fassade eines Hauses) - von unten nach oben durch die Thermoanordnung bzw. die mehreren Thermoanordnungen der Photovoltaikmodulanordnung(en) strömt. Durch diese Ausgestaltung der Photovoltaikmodulanordnung kann in dem Wellrohr der Thermoanordnung beim Erwärmen des Medium ein thermischer Auftrieb entstehen, der in Strömungsrichtung des Medium weist und somit zu einem effizienteren Durchströmen des Wellrohrs und insbesondere ebenfalls zu einer Reduzierung der zum Befördern des Mediums durch das Wellrohr notwendigen Pumpleistung führen kann. Beispielsweise weist das Wellrohr der Thermoanordnung mehrere zumindest näherungsweise geradlinig verlaufende Teilabschnitte auf, die im montierten Zustand der Photovoltaikmodulanordnung zumindest näherungsweise horizontal verlaufen. Selbstverständlich kann die Thermoanordnung, auch wenn sie nicht zusammen mit einem Photovoltaikmodul verwendet wird, so angeordnet (montiert) werden, dass das Medium von unten nach oben durch die Thermoanordnung strömt, d.h. einen Auslass aufweist, der sich - in vertikaler Richtung betrachtet und auf den montierten Zustand der Thermoanordnung bezogen - oberhalb eines Einlasses der Thermoanordnung befindet. Denkbar ist natürlich auch, dass die Thermoanordnung als Solarthermievorrichtung verwendet wird, ohne sie mit einem Photovoltaikmodul zu kombinieren.

Darüber hinaus betrifft die Erfindung, wie oben ebenfalls bereits angedeutet, auch die Verwendung der erfindungsgemäßen Thermoanordnung als (energieeffiziente) Temperiervorrichtung zum Temperieren eines Raumes. Beispielsweise ist der zu temperierende Raum durch einen Boden, eine Decke und eine Wand begrenzt, wobei die Thermoanordnung zur Flächentemperierung in oder an einer Außen- oder Innenseite des Bodens, der Decke oder der Wand angeordnet sein kann. Denkbar ist natürlich auch, dass mehrere (z.B. miteinander verbundene) erfindungsgemäße Thermoanordnungen verwendet werden, von denen z.B. einige in der Decke, in dem Boden und in der Wand angeordnet sind. Bei dem Raum handelt es sich insbesondere um einen Raum eines Gebäudes. Denkbar ist jedoch auch, dass es sich um einen Raum eines Fahrzeuges (zum Beispiel einen Innenraum eines Zuges oder eines Schiffes) handelt.

Somit kann die erfindungsgemäße Thermoanordnung z.B. in bestehende Gebäude nachträglich eingebaut werden, ohne dass in die vorhandene Substanz und Bodenaufbau eingegriffen werden muss. Denkbar ist auch, dass die erfindungsgemäße Thermoanordnung als Fassadenelement, z.B. als Dämmung oder als Bestandteil einer Dämmung einer Außenwand eines Gebäudes, eingesetzt wird (d.h. an oder in einer Außenseite einer einen Raum des Gebäudes begrenzend Wand angeordnet wird). Im Sommer kann über die Thermoanordnung die Wärmeeinstrahlung abgetragen und einer energieeffizienten Nutzung, z.B. zum Erwärmen von Brauchwasser, zugeführt werden. Die Kühllast derartig ausgestatteter Gebäude kann somit im Sommer sinken. In Kombination mit einem Adsorber kann eine Raumkühlung realisiert werden.

Wie oben bereits im Zusammenhang mit der Photovoltaikmodulanordnung erläutert, kann die Thermoanordnung, auch wenn sie zur Temperierung eine Raumes dient, so angeordnet sein, dass das Medium von unten nach oben durch die Thermoanordnung strömt. Insbesondere weist die Thermoanordnung hierfür einen Einlass für das Medium in einem unteren Bereich und einen Auslass in einem oberen Bereich auf.

Die Erfindung betrifft auch ein Verfahren zum Herstellen einer wie oben beschriebenen Thermoanordnung, das die Schritte aufweist:
- Bereitstellen eines Wellrohres; und
- Einbetten zumindest eines Teilbereichs des Wellrohres in einen Materialbereich.

Insbesondere wird der Materialbereich in Form zweier Materialschaumplatten (insbesondere in Form zweier Graphitschaumplatten) bereitgestellt, wobei das Wellrohr zwischen den beiden Materialschaumplatten angeordnet und die so ausgebildete Anordnung aus den Materialschaumplatten und dem Wellrohr verpresst wird. Durch das Verpressen erhält die erzeugte Thermoanordnung insbesondere eine zumindest näherungsweise plattenförmige Gestalt, d.h. sie weist in einer Ebene eine deutlich größere (insbesondere eine mindestens dreimal größere) Ausdehnung auf als in einer Richtung senkrecht zu dieser Ebene.

Darüber hinaus kann an zumindest einer der Materialschaumplatten (zum Beispiel vor dem Anordnen zwischen den Materialschaumplatten) eine Folie, z.B. die erwähnte Metallfolie, angeordnet werden, wobei die Materialschaumplatte z.B. mit der Folie stoffschlüssig verbunden (etwa verklebt) wird.

Die Erfindung betrifft auch ein Verfahren zum Montieren einer Thermoanordnung aufweisend eine Leitung zum Führen eines Mediums, das Wärme aus der Umgebung aufnehmen und/oder Wärme an die Umgebung abgeben kann, und einen Materialbereich, in den die Leitung zumindest teilweise eingebettet ist, wobei die Thermoanordnung so montiert wird, dass das Medium von unten nach oben durch die Thermoanordnung strömt. Gemäß diesem Aspekt wird die Thermoanordnung in bestimmter Weise angeordnet, insbesondere um den oben bereits beschriebenen Auftriebseffekt zu nutzen, wobei die Leitung nicht zwingend als Wellrohr ausgebildet sein muss.

Die Erfindung wird im Folgenden anhand von Ausführungsbeispielen unter Bezugnahme auf die Figuren näher erläutert. Es zeigen:
- Fig. 1-4B: Schritte beim Herstellen einer Thermoanordnung gemäß einem Ausführungsbeispiel der Erfindung;
- Fig. 5, 6: Variante einer Thermoanordnung gemäß einem weiteren Ausführungsbeispiel der Erfindung;
- Fig. 7: eine Draufsicht auf eine Vorrichtung mit mehreren Thermoanordnungen gemäß den Figuren 5 und 6;
- Fig. 8: einen als Kassette ausgebildeten Rahmen für eine erfindungsgemäße Thermoanordnung;
- Fig. 9: eine Seitenansicht einer Vorrichtung mit mehreren erfindungsgemäßen Thermoanordnungen, die über einen Rahmen gemäß Fig. 8 miteinander verbunden sind;
- Fig. 10A: Eine Draufsicht auf die Kassette der Thermoanordnung der Figur 8;
- Fig. 10B: einen Ausschnitt einer an einer Wand oder Decke montierten Thermoanordnung;
- Fig. 11, 12: Varianten einer weiteren Ausführungsform der erfindungsgemäßen Thermoanordnung;
- Fig. 13: eine perspektivische Ansicht einer Thermoanordnung gemäß einer weiteren Ausgestaltung der Erfindung;
- Fig. 14: eine Draufsicht auf eine erfindungsgemäße Thermoanordnung zur Verwendung in einem Photovoltaikmodul;
- Fig. 15: eine Seitenansicht eines Rahmens eines Photovoltaikmoduls;
- Fig. 16: eine Seitenansicht einer erfindungsgemäßen Photovoltaikmodulanordnung;
- Fig. 17: eine Draufsicht auf eine Photovoltaikmodulanordnung gemäß einem weiteren Ausführungsbeispiel der Erfindung;
- Fig. 18: eine Detailansicht der Figur 17; und
- Fig. 19: eine weitere Detailansicht der Figur 17.

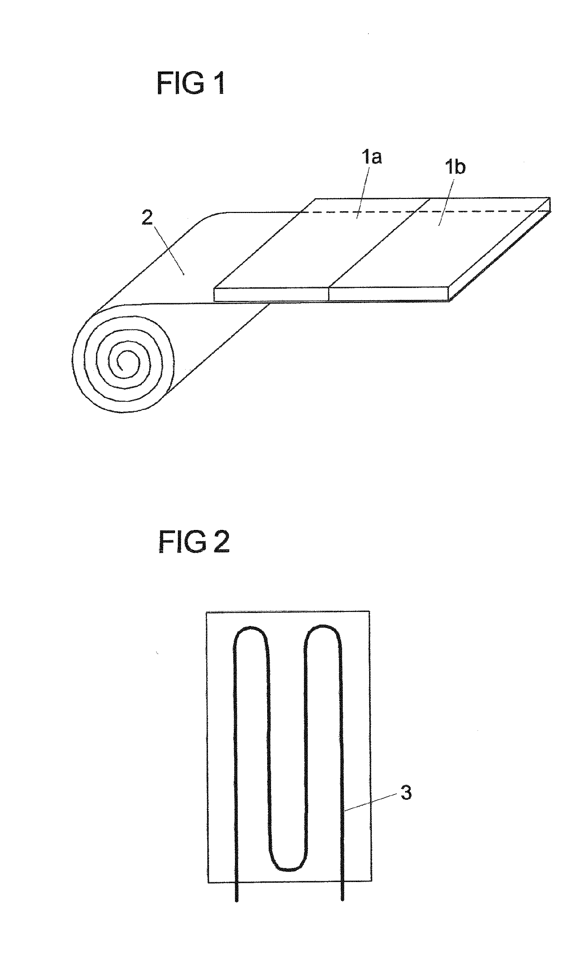

Gemäß dem in den Fig. 1 bis 4B dargestellten Ausführungsbeispiel des erfindungsgemäßen Verfahrens zum Herstellen einer Thermoanordnung werden zwei Materialschaumplatten in Form zweier Graphitschaumplatten 1a, 1b an einer Metallfolie in Form einer Aluminiumfolie 2 angeordnet, wobei jeweils eine Seite der Graphitschaumplatten 1a, 1b mit einer Oberfläche der Aluminiumfolie 2 verklebt wird. Anstelle der Graphitschaumplatten könnte auch ein anderes schichtförmiges Material (z.B. in Plattenform) verwendet werden. Darüber hinaus kann natürlich auch eine Folie 2 verwendet werden, die nicht aus einem Metall besteht, sondern z.B. aus einem Kunststoff. Nach dem Verkleben der Graphitschaumplatten 1a, 1b mit der Aluminiumfolie 2 wird ein über die Platten 1a, 1b überstehender Bereich der Folie 2 abgetrennt oder zumindest teilweise auf die Graphitschaumplatten 1a, 1 b umgeschlagen.

Des Weiteren wird gemäß Figur 2 eine Leitung in Form eines Wellrohres 3 bereitgestellt und in eine Mäanderform gebogen, wobei das Wellrohr 3 vier parallel zueinander verlaufende Teilabschnitte aufweist, die jeweils über eine Krümmung mit einem benachbarten Teilabschnitt verbunden sind. Selbstverständlich kann das Wellrohr auch mehr oder weniger Krümmungen, d.h. mehr oder weniger geradlinige Teilabschnitte aufweisen.

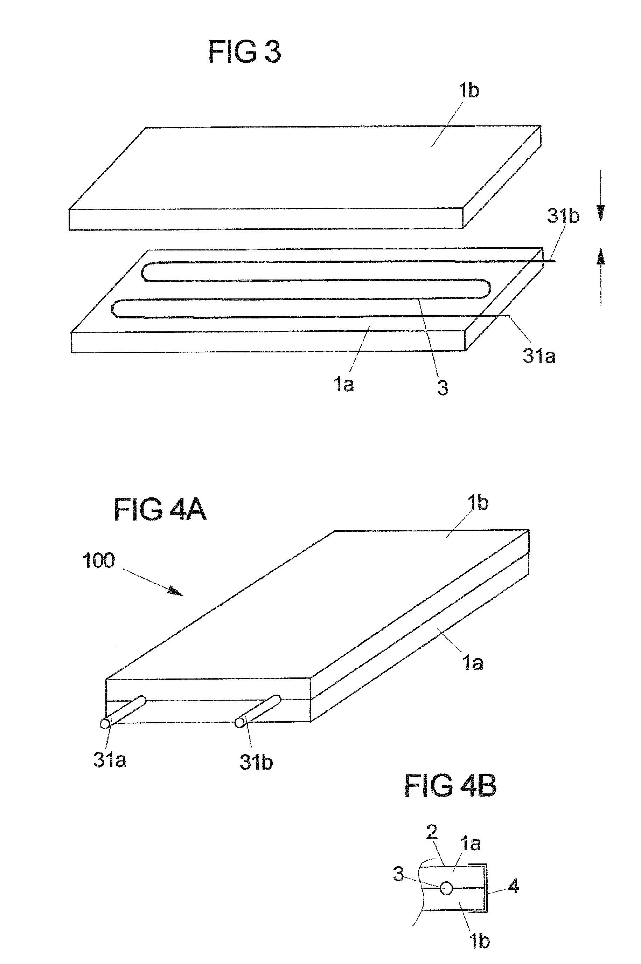

Das gemäß Figur 2 vorgebogene Wellrohr 3 wird zwischen den Graphitschaumplatten 1a, 1b angeordnet, so dass eine erste Seite des Wellrohrs 3 (z.B. durch Auflegen) in Kontakt mit der ersten Graphitschaumplatte 1a und eine zweite Seite in Kontakt mit der zweiten Graphitschaumplatte 1b gebracht werden. Das Wellrohr 3 ist im Verhältnis zur Länge der (rechteckigen) Graphitschaumplatten 1a, 1 b so ausgestaltet, dass jeweils ein Ende 31 a, 31 b der äußeren geradlinigen Teilabschnitte des Wellrohrs 3 über die Graphitschaumplatten 1a, 1b überstehen (vg. Fig. 4A). Diese Enden 31 a, 31 b bilden einen Einlass bzw. einen Auslass, über den ein Medium (z.B. Wasser oder eine Wasser aufweisende Flüssigkeit) in den eingebetteten Bereich des Wellrohrs 3 hinein bzw. aus diesem Bereich hinausströmen kann.

Nach dem Anordnen des Wellrohres 3 zwischen den beiden Graphitschaumplatten 1a, 1b (Fig. 3) wird die Anordnung aus den beiden Platten 1a, 1b und dem Wellrohr 3 verpresst, wobei zum Beispiel auf die gesamte Fläche der Graphitschaumplatten 1a, 1 b ein Druck (zum Beispiel unter Einwirkung einer Kraft von 5 t) ausgeübt wird. Die so erzeugte plattenförmige Anordnung 100 ("Sandwich") weist zum Beispiel eine Dicke von weniger als 30 mm, zum Beispiel 20-25 mm, auf. Des Weiteren ist das Wellrohr 3 im Bereich der Graphitschaumplatten 1a, 1b vollständig mit (verpresstem) Graphitschaum umgeben, d.h. der Umfang des Wellrohres 3 ist komplett mit Graphitschaum bedeckt. Durch die wellenförmige Ausgestaltung der Wandung des Wellrohres 3 ergibt sich somit eine oben bereits angesprochene "Verzahnung" des Graphitschaums mit der Wandung des Wellrohres 3 und somit eine besonders stabile Verbindung zwischen dem Wellrohr 3 und dem Graphitschaum der Platten 1a, 1 b.

Denkbar ist, dass nach dem Verpressen (oder auch vor dem Verpressen) die seitlichen Ränder der Graphitschaumplatten 1a, 1 b über ein zusätzliches Befestigungsmittel (zum Beispiel in Form eines Klebebands 4) miteinander verbunden und insbesondere abgedichtet werden. Dies ist in Figur 4B, die einen Schnitt durch die Thermoanordnung 10 zeigt, dargestellt. Denkbar ist auch, dass die Aluminiumfolie 2 über die Graphitschaumplatten 1 a, 1 b jeweils übersteht und nach dem Verpressen der Platten 1 a, 1b umgeschlagen und zum Beispiel an den Platten 1a, 1 b fixiert wird (z.B. mit einem Klebeband nach Art des Klebebandes 4).

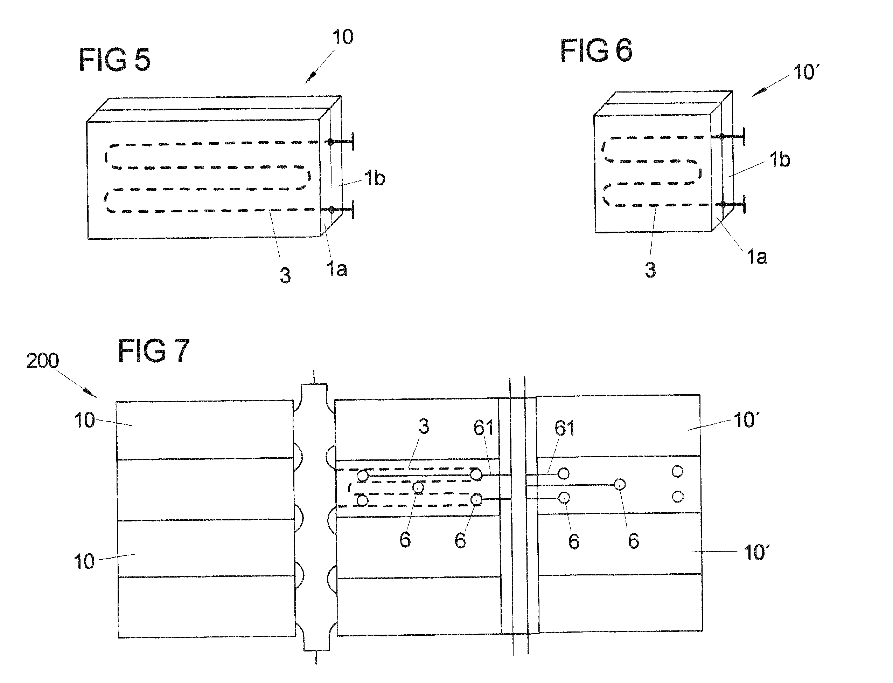

Selbstverständlich ist die Erfindung nicht auf eine bestimmte Geometrie der Graphitschaumplatten 1a, 1b und damit der Thermoanordnung begrenzt. Denkbar ist, dass die Graphitschaumplatten 1a, 1 b und damit die fertige Thermoanordnung eine in Draufsicht rechteckige Form aufweisen, wobei die Kantenlänge der Seiten, entlang derer sich die geradlinigen Teilabschnitte des Wellrohrs 3 erstrecken, größer ist als die Kantenlänge der Thermoanordnung senkrecht zu diesen Teilabschnitten (Fig. 5). Denkbar ist jedoch auch, dass die Thermoanordnung eine in Draufsicht andere (z.B. quadratische) Gestalt besitzt (Figur 6). Darüber hinaus können mehrere erfindungsgemäße Thermoanordnungen 10, 10' natürlich auch miteinander verbunden werden, wie in Figur 7 gezeigt. Hier sind mehrere Thermoanordnungen 10, 10' zu einer Verbundanlage 200 miteinander kombiniert, wobei jeweils die Wellrohre in vertikaler Richtung benachbarter Thermoanordnungen 10, 10' miteinander verbunden sind (d.h. in Strömungsverbindung miteinander stehen). Die Thermoanordnungen 10, 10' können zudem Aussparungen 6 aufweisen, in die insbesondere elektrische oder sonstige Komponenten (Leuchten, Schalter, Brandmelder, Lüftungselemente, etc.) eingesetzt werden können. Entsprechend können elektrische Leitungen 61 zu den Aussparungen verlaufen.

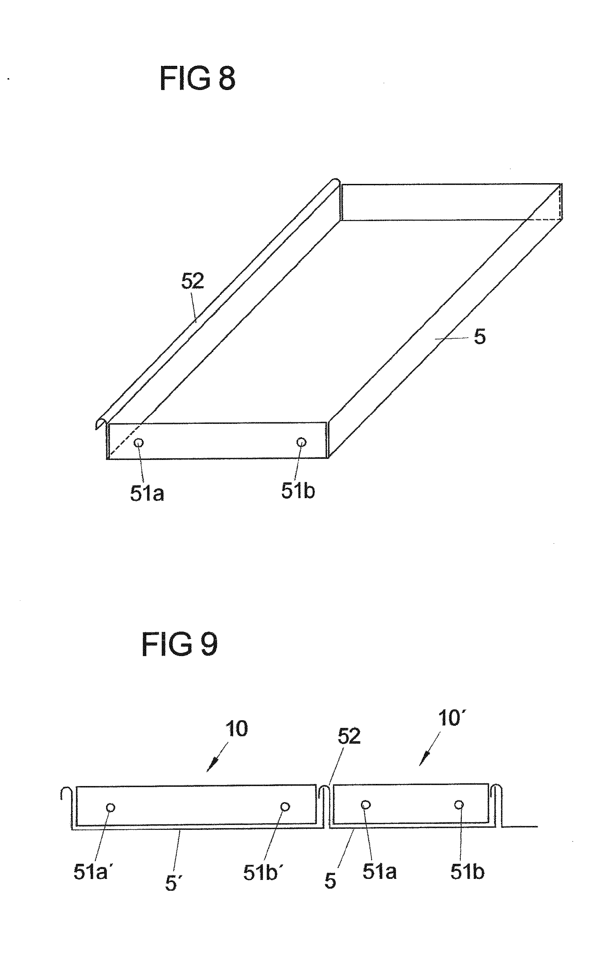

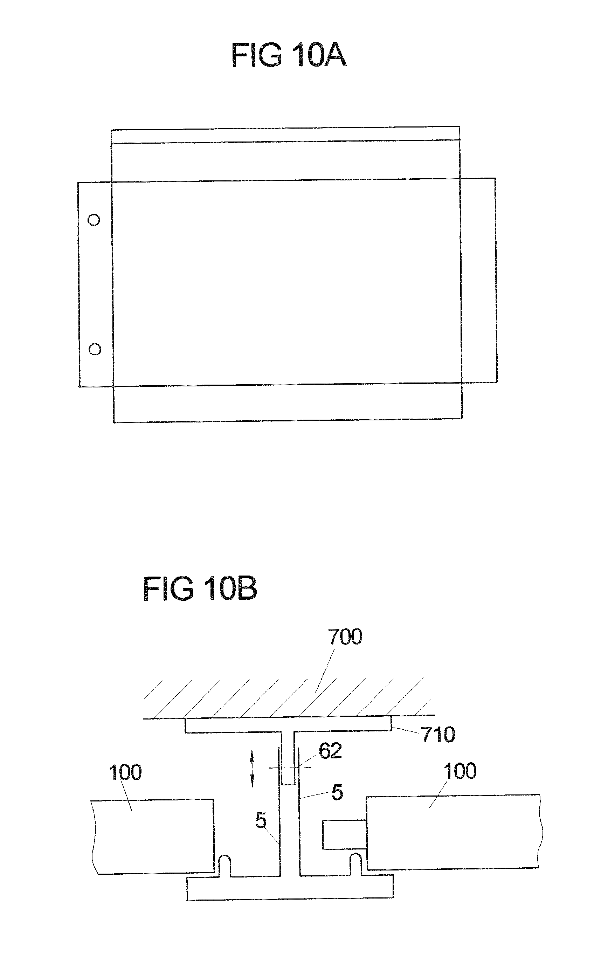

Figur 8 zeigt einen Rahmen in Form einer Kassette 5, in den das Sandwich aus den Graphitschaumplatten 1a, 1b und dem Wellrohr 3 (d.h. die Sandwichanordnung 100) eingelegt werden kann, insbesondere, um es an oder in einer Wand oder Decke oder als Bodenelement zu montieren. Der Rahmen 5 weist an einer seiner kürzeren Seiten zwei Öffnungen 51 a, 51 b auf, durch die die Enden 31 a, 31 b des Wellrohrs 3 hindurch geführt werden können. Des Weiteren besitzt der Rahmen 5 an einer seiner Längsseiten ein Befestigungsmittel in Form einer Auskragung 52, die sich zumindest näherungsweise über die gesamte Länge der Längsseite erstreckt und die dazu dient, den Rahmen 5 mit einem Rahmen einer weiteren Thermoanordnung zu verbinden. Hierzu wird die Auskragung 52 eines Rahmens einer ersten Thermoanordnung 10a an einer Seitenwand eines Rahmens 5 ' einer weiteren Thermoanordnung 10b eingehängt, wie in Figur 9 dargestellt. Der Rahmen 5 ist als aufgeklappter Materialzuschnitt (z.B. Blechzuschnitt) in Fig. 10A dargestellt.

Die Fixierung zweier benachbarter Kassetten kann auch über ein zusätzliches Befestigungsmittel (zum Beispiel über eine Rastverbindung oder eine Schraubverbindung) erfolgen, wie in Figur 10B gezeigt. Hier sind die Wandungen zweier Kassetten 5 über ein Befestigungselement 62 miteinander und mit einem an einer Decke 700 befestigten Halter 710 (insbesondere verstellbar) verbunden. Analog könnte eine Befestigung an einer Wand oder einem Boden erfolgen.

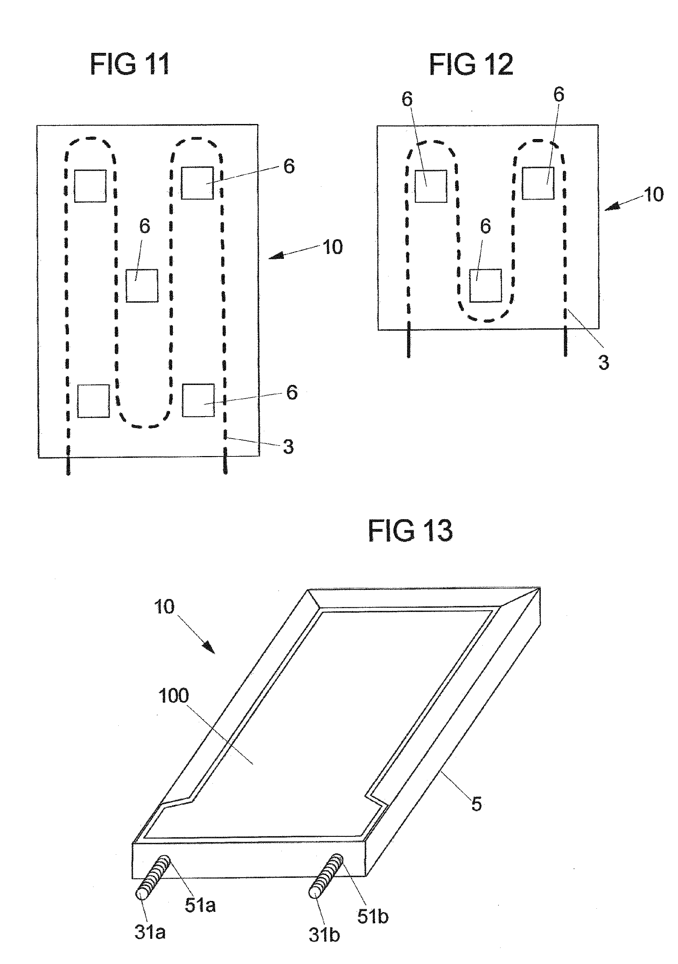

Insbesondere, wenn die erfindungsgemäße Thermoanordnung als Klima- oder Heizelement (Klima- oder Heizmatte) zum Temperieren eines Raumes verwendet und z.B. in einer Wand, einem Boden oder einer Decke des Raumes angeordnet werden soll, ist es denkbar, dass in den durch die Graphitschaumplatten 1a, 1b ausgebildeten Materialbereich Aussparungen 6 eingebracht werden, in die Komponenten, zum Beispiel von Versorgungseinrichtungen eines Gebäudes (zum Beispiel für Lichtschalter, Steckdosen, elektrische Leitungen, Lüftungsschächte, etc.) vorgesehen werden. Dies ist in Figur 11 für eine größere ("längliche") Thermoanordnung (vergleichbar der Thermoanordnung der Figur 5) und in Figur 12 für eine kleinere (z.B. quadratische) Thermoanordnung (vergleichbar der Thermoanordnung der Figur 6) dargestellt.

Figur 13 zeigt eine weitere Variante eines Rahmens 5 (Blechkassette), in die das Sandwich 100 aus Graphitschaumplatten 1a, 1b und Wellrohr 3 eingelegt werden kann; insbesondere bei einer Verwendung der Thermoanordnung als Temperiervorrichtung zum Temperieren eines Raumes. Der Rahmen 5 weist in diesem Beispiel entlang eines Teiles seiner Längsseiten verlaufende Laschen auf, die das Sandwich 100 in Position halten. In der so gebildeten Thermoanordnung 10 ragen die Enden 31 a, 31 b des Wellrohres 3 durch Öffnungen 51 a, 51 b des Rahmens 5 hindurch.

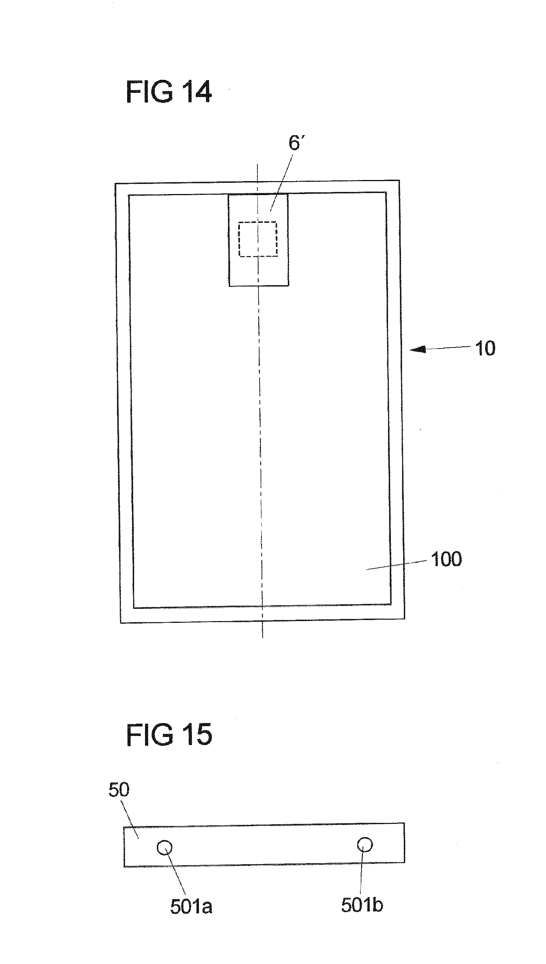

Für den Fall, dass die erfindungsgemäße Thermoanordnung als Bestandteil einer Photovoltaikmodulanordnung verwendet werden soll, kann der aus den Graphitschaumplatten 1a, 1 b gebildete Materialbereich eine (insbesondere rechteckig ausgebildete) Öffnung 6' aufweisen, die - bezogen auf die Längsausdehnung der Thermoanordnung 10 - mittig positioniert ist und zur Durchführen eines elektrischen Anschlusses des Photovoltaikmoduls dient (Fig. 14).

Zum Anordnen der erfindungsgemäßen Thermoanordnung 10 als Solarthermiekomponente an einem Photovoltaikmodul wird insbesondere auf einem separaten Rahmen für die Thermoanordnung verzichtet. Stattdessen wird die Thermoanordnung 10 (die in diesem Fall durch das bloße Sandwich 100 gebildet ist) mit in einen vorhandenen Rahmen 50 des Photovoltaikmoduls eingelegt. Hierfür wird z.B. der Rahmen 50 des Photovoltaikmoduls, wie in Figur 15 gezeigt, mit Öffnungen 501 a, 501 b versehen, durch die die Enden 31 a, 31 b des Wellrohres 3 der Thermoanordnung nach außen geführt werden können.

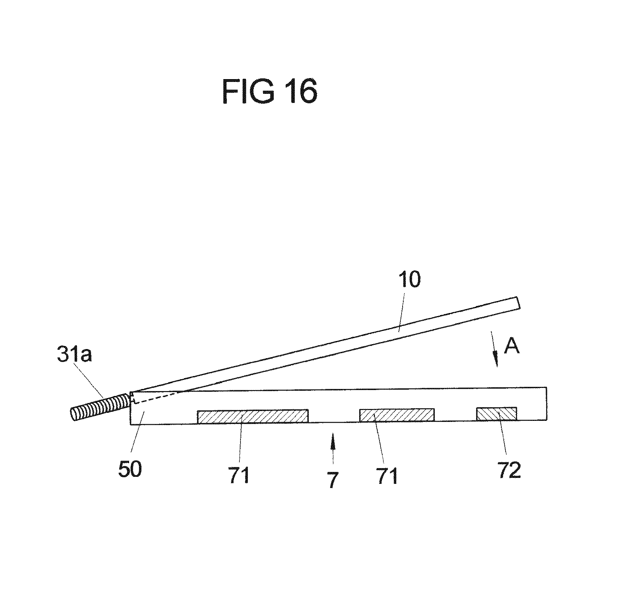

Beispielsweise erfolgt das Anordnen der Thermoanordnung 10 an einem Photovoltaikmodul 7 dadurch, dass zunächst die über die Graphitschaumplatten 1a, 1b überstehenden Enden 31 a, 31 b des Wellrohres 3 durch die in dem Rahmen 50 erzeugten Öffnungen 501 a, 501 b geführt werden (Fig. 16) und die Thermoanordnung 10 dann nach unten in Richtung auf die Rückseite der Fotozelle (nicht dargestellt) des Photovoltaikmoduls 7 geschwenkt wird (Pfeil A). Denkbar ist, dass an dem Photovoltaikmodul 7 (z.B. an dessen Rahmen 50) Stege 71 vorgesehen werden, die die Schwenkbewegung der Thermoanordnung 10 nach unten begrenzen. In der Endposition der Thermoanordnung wird ein elektrischer Anschluss 72 ("Dose") des Photovoltaikmodul 7 die Öffnung 6' der Thermoanordnung 10 durchgreifen.

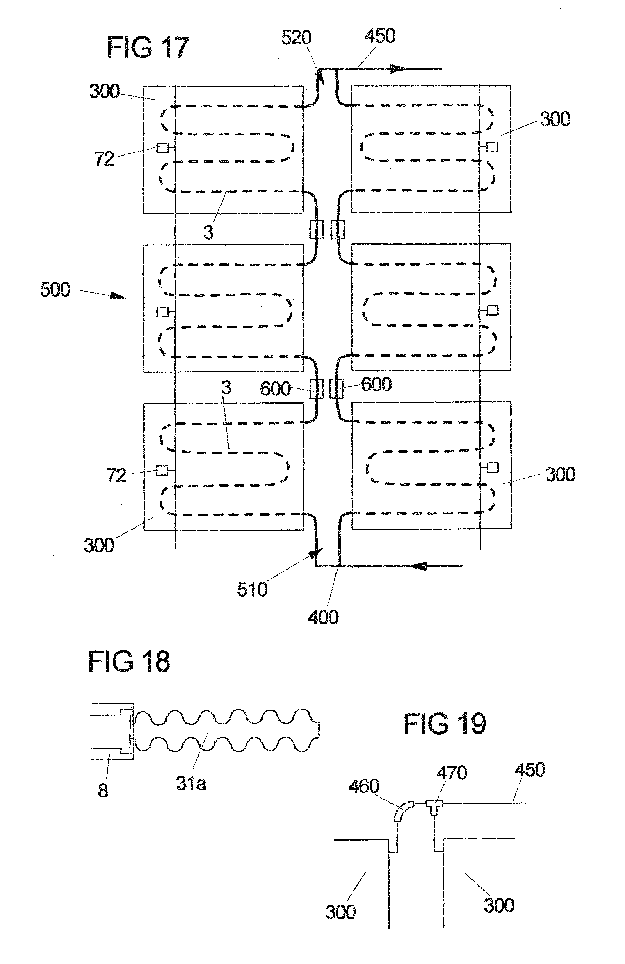

Gemäß Fig. 17 können mehrere auf diese Weise hergestellte kombinierte (hybride) Photovoltaikmodule 300 miteinander verbunden werden, um eine Photovoltaikmodulanordnung in Form einer Photovoltaikanlage 500 zu schaffen, die zum Beispiel auf dem Dach eines Gebäudes montiert werden kann. Hiernach sind in zwei Spalten jeweils drei der Photovoltaikmodule 300 angeordnet, wobei jeweils ein Einlass eines Photovoltaikmoduls (d.h. eines der Enden 31 a, 31 b des Wellrohrs 3 der Thermoanordnung des jeweiligen Photovoltaikmoduls) mit einem Auslass eines benachbarten Photovoltaikmoduls verbunden ist.

Die jeweils untersten Photovoltaikmodule 300 sind über einen Einlass 510 (der durch die unteren Enden der Wellrohre 3 der untersten Photovoltaikmodule 300 gebildet wird) der Photovoltaikanlage 500 mit einem ersten Sammelrohr (Zulauf) 400 verbunden, über die das Wärmemedium den Photovoltaikmodule 300 zugeführt wird. Entsprechend sind die beiden obersten Fotovoltaikmodulanordnungen über einen Auslass 520 (der durch die oberen Enden der Wellrohre 3 der obersten Photovoltaikmodule 300 gebildet wird) mit einem zweiten Sammelrohr (Ablauf) 450 verbunden, über die das erwärmte Medium abgeführt wird.

Die Photovoltaikmodule 300 sind jeweils so angeordnet, dass das Medium von unten nach oben durch die Photovoltaikanlage 500 (d.h. durch die Thermoanordnungen der einzelnen Photovoltaikmodule 300) strömt, so dass in den Leitungen (den Wellrohren 3) ein thermischer Auftrieb entsteht, der benutzt werden kann, um die zum Befördern des Mediums notwendige Pumpleistung zu reduzieren. Die geradlinigen Abschnitte der Wellrohre 3 der Thermoanordnungen verlaufen z.B. jeweils zumindest näherungsweise horizontal.

Die Enden 31 a, 31 b der Wellrohre 3 der Thermoanordnungen benachbarter Photovoltaikmodule 300 werden insbesondere über so genannte Doppelnippel 600 miteinander verbunden, wobei an zumindest einem Ende eine Überwurfmutter 8 befestigt wird (in Figur 18 für ein Ende 31 a gezeigt). Zum Verbinden der unteren Enden der beiden untersten Photovoltaikmodule bzw. der oberen Enden der beiden obersten Photovoltaikmodule mit dem ersten bzw. zweiten Sammelrohr 400, 450 können diese mit einem Bogenstück 460 bzw. einem T-Stück 470 versehen werden (Figur 19). Selbstverständlich ist die Erfindung jedoch nicht auf derartige Verbindungen festgelegt, sondern es können im Prinzip beliebige Verbindungsmittel benutzt werden.

Es wird darauf hingewiesen, dass Elemente der vorstehend beschriebenen Ausführungsbeispiele selbstverständlich auch in Kombination miteinander verwendet werden können. So kann zum Beispiel die in Figur 18 dargestellte Verbindung der Enden der Wellrohre über eine Überwurfmutter auch im Zusammenhang mit der Verwendung der erfindungsgemäßen Thermoanordnung als Temperiervorrichtung (Figur 13) benutzt werden.

### Bezugszeichenliste

- 1a, 1b: Graphitschaumplatte
- 2: Aluminiumfolie
- 3: Wellrohr
- 4: Klebeband
- 5, 5', 50: Rahmen
- 6, 6': Öffnung
- 7: Photovoltaikmodul
- 8: Überwurfmutter
- 10, 10', 10a, 10b: Thermoanordnung
- 31a, 31b: Ende Wellrohr
- 51a, 51b, 51a', 51b', 501a, 501b: Öffnung Rahmen
- 52: Auskragung
- 62: Befestigungselement
- 71: Steg
- 72: Anschluss
- 100: Sandwichanordnung
- 300: Photovoltaikmodul
- 400, 450: Sammelrohr
- 460: Bogenstück
- 470: T-Stück
- 500: Photovoltaikanlage
- 510: Einlass
- 520: Auslass
- 600: Doppelnippel
- 700: Decke
- 710: Halter

## Patentansprüche

1. Thermoanordnung, mit
- einer Leitung zum Führen eines Mediums, das Wärme aus der Umgebung aufnehmen und/oder Wärme an die Umgebung abgeben kann; und
- einem Materialbereich (1a, 1b), in den die Leitung zumindest teilweise eingebettet ist,
**dadurch gekennzeichnet, dass**
die Leitung in Form eines Wellrohres (3) ausgebildet ist.

2. Thermoanordnung nach Anspruch 1, **dadurch gekennzeichnet, dass** der Materialbereich (1a, 1b) einen Materialschaum aufweist oder aus einem Materialschaum gebildet ist.

3. Thermoanordnung nach Anspruch 2, **dadurch gekennzeichnet, dass** es sich bei dem Materialschaum um Graphitschaum handelt.

4. Thermoanordnung nach Anspruch 2 oder 3, **dadurch gekennzeichnet, dass** der Materialschaum verpresst ist, so dass die Thermoanordnung (10, 10') eine zumindest im Wesentlichen plattenförmige Form aufweist.

5. Thermoanordnung nach einem der vorhergehenden Ansprüche, **dadurch gekennzeichnet, dass** zumindest ein Teilabschnitt des Wellrohrs (3) entlang seines äußeren Umfanges vollständig von dem Materialbereich (1a, 1b) umgeben ist.

6. Thermoanordnung nach einem der vorhergehenden Ansprüche, **gekennzeichnet durch** mindestens eine Folie (2), die den Materialbereich (1a, 1 b), in den das Wellrohr (3) zumindest teilweise eingebettet ist, zumindest teilweise umgibt.

7. Thermoanordnung nach einem der vorhergehenden Ansprüche, **gekennzeichnet durch** zumindest eine Öffnung (6, 6') und/oder Vertiefung in dem Materialbereich (1a, 1 b) zum Anordnen von elektrischen und/oder mechanischen Komponenten (72).

8. Thermoanordnung nach einem der vorhergehenden Ansprüche, **gekennzeichnet durch** einen Einlass, über den das Medium in die Thermoanordnung (10, 10') einströmen kann, und einen Auslass, über den das Medium aus der Thermoanordnung (10, 10') ausströmen kann, wobei der Einlass und der Auslass so angeordnet sind und die Thermoanordnung (10, 10') so zu montieren ist, dass das Medium bei Betrieb der Thermoanordnung (10, 10') - bezogen auf den montierten Zustand der Thermoanordnung (10, 10') - von unten nach oben **durch** die Thermoanordnung (10, 10') strömt.

9. Photovoltaikmodulanordnung, mit mindestens einem Photovoltaikmodul (7) und mindestens einer an dem Photovoltaikmodul (7) angeordneten Thermoanordnung (10, 10') nach einem der vorhergehenden Ansprüche, wobei die Thermoanordnung (10, 10') in einen Rahmen (50) des Photovoltaikmoduls (7) eingesetzt ist.

10. Photovoltaikmodulanordnung nach Anspruch 9, **gekennzeichnet durch** einen Einlass (510), über den das Medium in die Thermoanordnung (10) einströmen kann, und einen Auslass (520), über den das Medium aus der Thermoanordnung (10) ausströmen kann, wobei der Einlass und der Auslass (510, 520) so angeordnet sind, dass das Medium bei Betrieb der Photovoltaikmodulanordnung (500) - bezogen auf den montierten Zustand der Photovoltaikmodulanordnung (500) - von unten nach oben **durch** die Thermoanordnung (10) strömt.

11. Verwendung mindestens einer Thermoanordnung nach einem der Ansprüche 1 bis 8 als Temperiervorrichtung zum Temperieren eines Raumes oder als Solarthermievorrichtung.

12. Verwendung nach Anspruch 11, **dadurch gekennzeichnet, dass** die Thermoanordnung (10, 10') so angeordnet ist, dass das Medium von unten nach oben durch die Thermoanordnung (10, 10') strömt.

13. Verfahren zum Herstellen einer Thermoanordnung nach einem der Ansprüche 1 bis 8, mit den Schritten:
- Bereitstellen einer Leitung in Form eines Wellrohres (3); und
- Einbetten zumindest eines Teilbereichs des Wellrohres (3) in einen Materialbereich (1a, 1b).

14. Verfahren nach Anspruch 13, **dadurch gekennzeichnet, dass** zum Ausbilden des Materialbereichs (1a, 1b) zwei Materialschaumplatten bereitgestellt werden, wobei das Wellrohr (3) zwischen den beiden Materialschaumplatten angeordnet und die so ausgebildete Anordnung aus den Materialschaumplatten und dem Wellrohr (3) verpresst wird.

15. Verfahren zum Montieren einer Thermoanordnung aufweisend eine Leitung zum Führen eines Mediums, das Wärme aus der Umgebung aufnehmen und/oder Wärme an die Umgebung abgeben kann, und einen Materialbereich, in den die Leitung zumindest teilweise eingebettet ist, **dadurch gekennzeichnet, dass** die Thermoanordnung so montiert wird, dass das Medium von unten nach oben durch die Thermoanordnung strömt.
